(19) Europäisches Patentamt
European Patent Office
Office européen des brevets

(11) EP 0 707 952 A1

(12) EUROPÄISCHE PATENTANMELDUNG

(43) Veröffentlichungstag:
24.04.1996 Patentblatt 1996/17

(51) Int. Cl.⁶: $B32B\ 18/00$, $H05K\ 1/16$, $H01G\ 4/12$, $C04B\ 35/16$

(21) Anmeldenummer: 95202661.5

(22) Anmeldetag: 04.10.1995

(84) Benannte Vertragsstaaten:
DE FR GB

(30) Priorität: 12.10.1994 DE 4436440

(71) Anmelder:
• Philips Patentverwaltung GmbH
D-22335 Hamburg (DE)
Benannte Vertragsstaaten:
DE
• PHILIPS ELECTRONICS N.V.
NL-5621 BA Eindhoven (NL)
Benannte Vertragsstaaten:
FR GB

(72) Erfinder:
• Mateika, Dieter, Dr.
D-22335 Hamburg (DE)
• Zillikens, Christoph
D-22335 Hamburg (DE)

(74) Vertreter: Volmer, Georg, Dipl.-Ing. et al
Philips Patentverwaltung GmbH,
Röntgenstrasse 24
D-22335 Hamburg (DE)

(54) Keramischer Schichtverbundkörper, Verfahren zu seiner Herstellung und Modul

(57) Ein keramischer Schichtverbundkörper aus einem elektrokeramischen Material für elektronische Bauelemente und einem elektrisch isolierenden Material für Entkopplungsschichten, das dadurch gekennzeichnet ist, daß das Material für die Entkopplungsschichten im wesentlichen aus einem einfachen oder substituierten Orthosilikat der Elemente Magnesium, Kalzium, Strontium, Barium und/oder Titan besteht, hat den Vorteil, daß diese Orthosilikate in demselben Temperaturbereich wie die üblichen elektrokeramischen Materialien sintern. Deshalb können beide Materialien, die Elektrokeramik und das Entkopplungsmaterial, kogesintert werden.

Die Erfindung betrifft weiterhin ein Verfahren zur Herstellung eines solchen keramischen Schichtverbundkörpers sowie ein Modul mit einem erfindungsgemäßen keramischen Schichtverbundkörper.

EP 0 707 952 A1

## Beschreibung

Die vorliegende Erfindung betrifft einen keramischen Schichtverbundkörper aus einem elektrokeramischen Material für elektronische Bauelemente und einem elektrisch isolierenden Material für Entkopplungsschichten. Sie betrifft weiterhin ein Verfahren zur Herstellung eines solchen keramischen Schichtverbundkörpers sowie ein Modul mit einem keramischen Schichtverbundkörper.

Elektronische Bauelemente, wie z.B. Kondensatoren, Widerstände und Spulen werden in ihren Abmessungen immer kleiner Im Rahmen dieser Miniaturisierung wird die Integration mehrerer solcher Komponenten in einem Modul angestrebt. Dabei sind die Bauelemente in einem derartigen Modul im allgemeinen in mehreren Schichten übereinander angeordnet. Für die technische Anwendung ist es wichtig, daß die in Schichten angeordneten Bauelemente durch Entkopplungsschichten elektrisch voneinander entkoppelt werden. Integrierte Module nach dem Stand der Technik umfassen daher in ihrem Aufbau Schichtverbundkörper aus elektronischen Bauelementen und Entkopplungsschichten, außerdem noch elektrische Kontakte, Zwischenverbindungen, Substratplatten usw.

Für die elektronischen Bauelemente werden keramische, meist dielektrische Materialien verwendet. Insbesondere für Kondensatoren und Speicher werden elektrokeramische Zusammensetzungen eingesetzt, deren Hauptbestandteil titanhaltige Perowskite sind. Die technisch wichtigsten Verbindungen dieser Art basieren auf Bariumtitanat, $BaTiO_3$, und dessen Mischkristalle (Feste Lösungen) sowie auch auf Bleizirkontitanat, $Pb(Zr,Ti)O_3$ und dessen Mischkristalle.

In Gassensormodulen werden andererseits elektrokeramische Zusammensetzungen auf der Basis von Zinndioxid verwendet. Auch verschiedene Ferrite werden als elektrokeramisches Material eingesetzt, hauptsächlich in Spulen und Übertragern.

Für die Entkopplungsschichten nach dem Stand der Technik werden spezielle Gläser mit kleinen Werten für die Dielektrizitätskonstante $\varepsilon$ verwendet.

Solche Gläser haben niedrige Schmelzpunkte, die bei < 700°C liegen. Andererseits müssen die elektrokeramischen Materialien für die elektronischen Bauelemente bei sehr viel höheren Temperaturen von T > 1150°C gesintert werden. Deswegen ist es nicht möglich, die Bauelemente zusammen mit den Entkopplungsschichten in einem Schritt fertig zu sintern.

Die Herstellung der Module nach dem Stand der Technik erfolgt daher in einem mehrstufigen Prozeß. Zunächst werden die elektronischen Bauelemente für sich fertig gestellt. Dann werden sie in einer Ebene auf einem Substrat montiert. Anschließend wird auf diese Komponentenebene eine Glaspaste aufgetragen und der gesamte Aufbau bei niedrigen Temperaturen eingebrannt. Hierbei wandelt sich die Glaspaste in eine Glasschicht um.

Danach wird in einem weiteren Arbeitsschritt die nächste Ebene Bauelemente gleicher oder anderer Bauart montiert und wieder mit einer Glasschicht abgedeckt. Diese Arbeitsvorgänge werden mehrmals wiederholt. Die Glasschicht verbindet und hält die übereinander gestapelten elektronischen Bauelemente und dient gleichzeitig zur elektrischen Entkopplung zwischen den Schichtebenen aus den Bauelementen.

Der mehrstufige Herstellungsprozeß für solche Module ist dabei weitgehend Handarbeit. Er ist kompliziert und kostenaufwendig. Weiterhin ist es schwierig, die verschiedenen Komponenten genau zu positionieren und dieselben untereinander elektrisch zu verbinden.

Da die zuverlässige Montage und Verbindung innerhalb eines Moduls jedoch ein sehr kritischer Punkt ist, von dem das zuverlässige Funktionieren des Gesamtsystems entscheidend abhängt, ist es die Aufgabe der vorliegenden Erfindung, einen keramischen Schichtverbundkörper aus einem elektrokeramischen dielektrischen Werkstoff für elektronische Bauelemente und einem Material für die dazwischenliegenden Entkopplungsschichten zur Verfügung zu stellen, der einfacher und sicherer gefertigt werden kann und verbesserte Eigenschaften zeigt.

Die Erfindung betrifft weiterhin ein vereinfachtes Verfahren zur Herstellung eines solchen Schichtverbundkörpers.

Ein weiterer Aspekt der Erfindung betrifft ein verbessertes Modul.

Bezüglich des keramischen Schichtverbundkörpers wird die erfindungsgemäße Aufgabe gelöst durch einen keramischen Schichtverbundkörper (Composite) aus einem elektrokeramisches Material für elektronische Bauelemente und einem elektrisch isolierenden Material für Entkopplungsschichten, bei dem daß das Material für die Entkopplungsschichten im wesentlichen aus einem einfachen oder substituierten Orthosilikat der Elemente Magnesium, Kalzium, Strontium, Barium und/oder Titan besteht.

Die Verwendung von Orthosilikaten der Elemente Beryllium, Magnesium, Kalzium, Strontium, Barium und/oder Titan als Material für Entkopplungsschichten in einem Schichtverbundkörper mit elektrokeramischem Material hat den Vorteil, daß diese Orthosilikate bei hohen Temperaturen zwischen 1000°C und 1400°C gesintert werden können, in demselben Temperaturbereich in dem die üblichen elektrokeramischen Materialien sintern. Deshalb können beide Materialien, die Elektrokeramik und das Entkopplungsmaterial, simultan im Kontakt miteinander gesintert werden (Kosinterung).

Die erfindungsgemäßen Orthosilikate sind außerdem gute elektrische Isolatoren. Sie haben eine Dielektrizitätskonstante $\varepsilon$ < 20, gemessen bei 1 kHz und gleichzeitig liegen die dielektrischen Verluste bei $tg\ \delta \leq 1 \times 10^{-3}$, sodaß sie sich sehr gut als Entkopplungsmaterial eignen.

Im Rahmen der vorliegenden Erfindung ist es bevorzugt, daß das Orthosilikat ein substituiertes Orthosilikat der Zusammensetzung $Ba_{2-x}Sr_xTiSi_2O_8$ mit $0 \leq x \leq 2$,

$Ba_{3-x}Ca_xMgSi_2O_8$ mit $0 \leq x \leq 2$ oder $Mg_{2-x}Ca_xSiO_4$ mit $0 \leq x \leq 0.5$ ist.

Diese Orthosilikate haben eine Sintertemperatur zwischen 1130°C und 1290°C und eignen sich daher besonders gut für einen kogesinterten Schichtverbundkörper.

Es kann auch bevorzugt sein, daß das elektrokeramische Material ein titanhaltiger Perowskit ist.

Besondere Vorteile zeigt die Erfindung, wenn das elektrokeramische Material ein titanhaltiger Perowskit ist. Titanhaltige Perowskite reagieren nicht chemisch mit den erfindungsgemäßen Orthosilikaten, sondern bilden eutektische Systeme. Dadurch wird eine besonders gute Haftung in dem Schichtverbund erhalten.

Eine besonders bevorzugte Ausführungsform besteht darin, daß das elektrokeramische Material ein mit Niob, Kobalt und Mangan dotiertes Bariumtitanat ist und das Orthosilikat die Zusammensetzung $Ba_2TiSi_2O_8$, $Ba_{1,6}Sr_{0,2}TiSi_2O_8$, $Sr_2TiSi_2O_8$, $Ba_3MgSi_2O_8$, $Ba_{2,7}Ca_{0,3}MgSi_2O_8$, $BaCa_2MgSi_2O_8$, $Mg_2SiO_4$ oder $Mg_{1,6}Ca_{0,4}SiO_4$ hat.

Bei diesen Materialpaarungen sind die Unterschiede in den thermischen Ausdehnungskoeffizienten zwischen der Elektrokeramik und dem Entkopplungsmaterial gering, sodaß es weder während der Sinterung noch während einer thermischen Belastung im Gebrauch zu Spannungen oder gar Rißbildung zwischen den Schichten kommt.

Nach dem erfindungsgemäßen Verfahren wird der keramische Schichtverbundkörper zunächst als grüner Formkörper gefertigt und anschließend der grüne Formkörper gesintert.

Ein solches Verfahren erspart gegenüber den Zusammensetzen der fertig gesinterten Bauelemente mit Glasschichten mehrere Fertigungstufen und erlaubt einen einfach zu kontrollierenden Prozeßablauf.

Das Modul nach der Erfindung umfasst einen erfindungsgemäßen keramischen Schichtverbundkörper, insbesondere einen solchen der nach dem erfindungsgemäßen Verfahren hergestellt ist.

Solche Module sind einfach zu fertigen, da der Aufbau zunächst vollständig aus grüner Keramik für die Bauelemente und die Entkopplungsschichten zusammengesetzt werden kann, und dann erst die Sinterung erfolgt. Dadurch fallen die vielen Fertigungsstufen für das Aufbringen und Brennen der Entkopplungsschichten aus Glas weg. Der Prozeß kann besser automatisiert werden und die Qualitätskontrolle ist erleichtert.

Im folgenden wird die Erfindung weiter erläutert und es werden Beispiele aufgeführt.

Die erfindungsgemäßen Module setzen sich aus elektronischen Bauelementen und ein oderer mehreren Entkopplungsschichten zusammen. In den erfindungsgemäßen Modulen kann eine Packungsdichte bis zu 150 Bauelementen pro $cm^2$ erreicht werden. Um diese Module zu realisieren, werden Dünnschichtkondensatoren, Widerstände, Spulen, Speicher, Sensoren u.ä. und die notwendigen Zwischenverbindungen auf einem Substrat, beispielsweise aus Silizium, kombiniert. Diese Module können selbst wieder als Baustein in integrierte Schaltungen eingebaut werden oder als Träger für aktive Komponenten dienen.

Die elektronischen Bauelemente sind als vorgegeben und optimiert zu betrachten. Die Materialien, die zu ihrer Herstellung verwendet werden, sind häufig titanhaltige Perowskite. Eine große Gruppe der titanhaltigen Perowskite basiert auf Bariumtitanat, $BaTiO_3$, und dessen Mischkristallen, wie Barium-Strontium-Titanat, Barium-Calcium-Titanat, Bariumniobat-titanat, Bariumtantalat-titanat usw. Wegen ihrer dielektrischen bzw. ferroelektrischen Eigenschaften verwendet man diese Werkstoffe für Bauelemente wie Kondensatoren und Speicher. Eine andere große Gruppe umfaßt die substituierten Bleititanate, insbesondere Bleizirkontitanate, die für Filter und Aktuatoren Verwendung finden.

Als Materialien für die Entkopplungsschicht werden erfindungsgemäß ein oder mehrere Orthosilikate, die als Kationen Magnesium, Calcium, Strontium , Barium und/oder Titan enthalten, verwendet. Diese Orthosilikate enthalten diskrete $SiO_4^{4-}$-Anionen. Wegen ihrer Inselstruktur werden sie auch als Inselsilikate bezeichnet. Die Kationen besetzen Zwischengitterplätze mit einer ihrer Ionengröße entsprechenden Sauerstoffkonfiguration. Die einfachen Orthosilikate haben die Zusammensetzung $Me_nSiO_4$. Die Struktur der Orthosilikate ermöglicht auch eine ausgedehnte Bildung von Mischkristallreihen der Orthosilikate untereinander, die zu substituierten Orthosilikaten führt.

Es findet jedoch keine Reaktion zwischen den Silikaten der Entkopplungsschicht und dem elektrokeramischen Material der elektronischen Bauelemente statt.

Besonders vorteilhafte Eigenschaften haben Mischkristallreihen gezeigt, die von $Ba_2TiSi_2O_8$, $Ba_3MgSi_2O_8$ oder $Mg_2SiO_4$ ausgehen und fortlaufende Mischkristallreihen unter Ersatz durch Calcium oder Strontium bilden.

Der Herstellungsprozeß für ein erfindungsgemäßes Modul gliedert sich auf in die folgenden Stufen:

- Herstellung des elektrokeramischen Materials und der Orthosilikate als Pulver,
- Aufbau eines grünen Körpers,
- Sintern des grünen Körpers,
- Endbehandlung.

Die Herstellung des elektrokeramischen Materials, wie titanhaltige Perowskite, Ferrite, Zinnoxid u.ä. erfolgt nach den bekannten Methoden. Diese Verbindungen sind zum Teil auch im Handel erhältlich.

Zur Herstellung der erfindungsgemäßen Orthosilikate als Pulver wird üblicherweise die "Mixed Oxide"-Technik verwendet, d.h. es werden die entsprechenden binären Oxide als Rohstoffe eingesetzt. Diese Ausgangsoxide sollten eine besonders hohe chemische Reinheit und eine gleichmäßig kleine Korngröße $< 1\mu m$ haben.

Die Ausgangsoxide werden, den molaren Gewichtsverhältnissen entsprechend, abgewogen, trocken oder naß vermahlen, gegebenenfalls getrocknet, dann bei 900 bis 1200°C kalziniert.

Die Ausgangsmischungen können allerdings auch aus den entsprechenden Karbonaten, Alkoxylaten oder anderen Verbindungen, die sich leicht und ohne Rückstände zu den Oxiden zersetzen lassen, gemischt werden. Sie könne auch durch Kopräzipitation, Sol-Gel-Verfahren oder Hydrothermalsynthese gewonnen werden.

Das durch die Kalzination bereits vorverdichtete Pulver aus elektrokeramischen Material bzw. Orthosilikaten kann mit keramischen Hilfstoffen versetzt werden und noch einmal gemahlen werden.

Für die Formgebung werden die so vorbereiteten Pulver mit einer Bindemittelzubereitung versetzt. Diese Zubereitungen enthalten im allgemeinen neben dem eigentlichen Bindemittel und einem Lösungsmittel wie Wasser oder organischen Lösungsmitteln noch Plastifizierer, Verflüssiger, Benetzungsmittel u.ä.

Zur Herstellung des grünen Körpers aus passiven Komponenten und Entkopplungsschichten für Module können verschiedene Verfahren verwendet werden.

Es können zunächst grüne keramische Folien sowohl aus dem Komponentenmaterial als auch aus dem Entkopplungsmaterial gezogen werden, die dann gestapelt werden. Es können aber auch Schichten im Siebdruckverfahren oder Rakelverfahren aufgebracht werden.

Es ist auch möglich nach anderen bekannten Verfahren vorzugehen. Es können die kalzinierten Pulver schichtweise gemeinsam verpreßt oder extrudiert werden oder es kann ein Formgießverfahren angewandt werden.

Die grünen Formkörper werden getrocknet und vorgebrannt, um die Komponenten der Bindemittelzubereitung auszutreiben.

Es ist ein großer Vorteil des erfindungsgemäßen Schichtverbundkörpers, daß der Verbund zunächst im grünen Zustand komplett zusammengestellt werden kann und dann als letzter Schritt vor der Nachbehandlung der gesamte Verbund gemeinsam dicht gesintert - "kogesintert" - wird.

Die Sinterung erfolgt bei Temperaturen zwischen 1000°C und 1400°C.

Anschließend wird der fertige Schichtverbundkörper gegebenenfalls noch mechanisch bearbeitet. Danach werden die elektrischen Kontakte und Zwischenverbindungen angebracht.

## Ausführungsbeispiele

### Herstellung des Entkopplungsmaterials

Für die Herstellung eines substituierten Orthosilikates der Zusammensetzung $Mg_{1.6}Ca_{0.4}SiO_4$ werden 94,676g MgO, 54,472g $CaCO_3$ und 81,740g $SiO_2$ in einer Planetenkugelmühle zwei Stunden in Cyclohexan gemischt. Anschließend wird die Mischung unter einer IR-Lampe an Luft getrocknet. Die Kalzination des Pulvers erfolgt bei 1050°C für sechs Stunden an Luft. Um ein möglichst feines, wenig agglomeriertes Pulver zu erhalten, wird die kalzinierte Mischung 4 Stunden auf der Rollenbank gemahlen. Als Mahlflüssigkeit wird Isopropanol benutzt, die Mahlkugeln bestehen aus $ZrO_2$. Nach dem Mahlen wird das Pulver wieder unter einer IR-Lampe getrocknet.

### Herstellung eines Moduls

Für die Herstellung eines Moduls werden zunächst 20 grüne Folien aus dem elektrisch isolierenden Material für die Entkopplungsschichten $Mg_{1.6}Ca_{0.4}SiO_4$ hergestellt. Diese Folien haben die Abmessungen 5 x 5 cm$^2$ und sind 40μm dick.

Außerdem werden 80 grüne Folien aus dotiertem Bariumtitanat (X7R, TAM Electronics Ltd.) mit den gleichen Abmessungen hergestellt. Diese Folien werden mit einer Palladium-paste für die Elektroden bedruckt.

Zum Aufbau des Moduls werden zunächst 5 Folien aus dem elektrisch isolierenden Entkopplungsmaterial als Unterlage benutzt. Auf diese Unterlage werden 40 bedruckte $BaTiO_3$ - folien gestapelt und danach mit 5 Folien aus dem elektrisch isolierenden Entkopplungsmaterial abgedeckt. Ein weiteres Schichtpaket aus $BaTiO_3$ - Folien und 5 Folien aus Entkopplungsmaterial wird anschließend auf das erste Schichtpaket gesetzt.

Beide Schichtpakete werden nach dem Compact-Verfahren bei 25 bar und 1200°C in einer Atmosphäre von Sauerstoff gesintert.

### Testergebnisse

Für die Testung der erfindungsgemäßen Entkopplungsmaterialien wurden jeweils 20 Verbindungen aus den Mischkristallreihen $Ba_{2-x}Sr_xTiSi_2O_8$ mit $0 \leq x \leq 2$, $Ba_{3-x}Ca_xMgSi_2O_8$ mit $0 \leq x \leq 2$ und $Mg_{2-x}Ca_xSiO_4$ mit $0 \leq x \leq 0.5$ hergestellt.

Aus diesen Verbindungen wurden für die Bestimmung des Sinterverhaltens und für die Messungen der Ausdehnungskoeffizienten Probekörper mit den Abmessungen 16 x 5 x 4 mm$^3$ hydrostatisch gepreßt. Diese Probekörper wurden anschließend an Luft mit einer Heizrate von 250°C/h auf 1350°C aufgeheizt.

Zur Bestimmung der Dielektrizitätskonstanten und der dielektrischen Verluste der Orthosilikate wurden Pillen mit einem Durchmesser von 6 mm und einer Dicke von 0,5 mm isostatisch gepreßt. Auch diese Pillen wurden anschließend an Luft bei 1280°C 6 Stunden gesintert.

Zur Testung der Kosinterungseigenschaften wurden Doppelpillen aus einem titanhaltigem Perowskit und einem Orthosilikat isostatisch gepreßt. Dazu wurde zunächst das Orthosilikat-Pulver in eine entsprechende zylindrische Preßform eingefüllt und isostatisch mit einem Preßdruck von 400 bar verdichtet. Anschließend wurde ein Perowskitpulver in die Preßform eingefüllt und zusammen mit dem vorverdichteten Silikatpulver bei 500 bar zu einer Doppelpille mit 20 mm Durchmesser und ca. 2mm Dicke verpreßt. Diese Doppelpille wird anschließend in einem Heißpreßverfahren bei 1167°C und 25 bar gesintert.

1. Sinterverhalten
Das Sinterverhalten der Proben wurde mit einem Hochtemperatur-Dilatometer bestimmt. Die Dilatometerkurven beschreiben die Längenänderung der keramischen Quader mit der Temperatur und geben damit Auskunft über das Sinterverhalten des untersuchten Materials. Der Beginn der Längenänderung entspricht dem Sinteranfang. Das Maximum der Dilatometerkurve gibt die maximale Sintergeschwindigkeit wieder. Das Ende der Volumenänderung ist auch gleichzeitig das Ende des Sintervorganges.

Es wurden jeweils die Sinterkurven einer Materialpaarung aus einem Perowskitmaterial, das für Kondensatoren eingesetzt wird, und einem Orthosilikatmaterial verglichen.

Für die Mischkristalle aus der Reihe $Ba_{2-x}Sr_xTiSi_2O_8$ mit $0 \leq x \leq 2$ nimmt die Temperatur des Sintermaximums von 1290°C für x = 0 bis zu 1143°C für x = 2 ab.

Für die Mischkristalle aus der Reihe $Ba_{3-x}Ca_xMgTiSi_2O_8$ mit $0 \leq x \leq 2$ verschiebt sich die Temperatur des Sintermaximums von 1272°C für x = 0 bis zu 1194°C für x = 2.

Für die Mischkristalle aus der Reihe $Mg_{2-x}Ca_xSiO_4$ mit $0 \leq x \leq 0.5$ verschiebt sich die Temperatur des Sintermaximums mit steigendem Ca-Gehalt zu niedrigeren Temperaturen, d.h. von 1330°C für x = 0 bis zu 1230°C für x = 0.5.

Aufgrund dieser linearen Relation der Sintertemperatur zu der Zusammensetzungen innerhalb einer Mischkristallreihe läßt sich für jede Elektrokeramik ein passendes Entkopplungsmaterial auswählen.

Zur Untersuchung des Kosinterungsverhaltens wurden Schliffe der gesinterten Doppelpillen hergestellt und rasterelektronenmikroskopisch untersucht.

Beide Schichten sind dicht gesintert und zeigen keinerlei Poren. Sowohl in den Schichten aus Elektrokeramik und Entkopplungsmaterial als auch an der Grenzfläche zwischen beiden Materialien wurden weder Risse noch andere Materialfehler gefunden.

2. Thermische Ausdehnungskoeffizienten
Nachdem die thermischen Ausdehnungskoeffizienten von Elektrokeramik und Entkopplungsmaterial einen Einfluß auf die Ausbildung von mechanischen Spannungen an der Grenzfläche haben, wurden diese ebenfalls bestimmt.

Die erfindungsgemäßen Entkopplungsmaterialien haben thermische Ausdehnungskoeffizienten von $6 \times 10^{-6}/K < \alpha < 14 \times 10^{-6}/K$ und stimmen damit mit dem gängigen elektrokeramischen Materialien überein. Insbesondere zeigt die Kombination von $Sr_2TiSi_2O_8$ mit einem mit Niob, Kobalt und Mangan dotiertem Bariumtitanat, beispielsweise X7R von TAM Ceramics Inc., eine besonders gute Übereinstimmung der thermischen Ausdehnungskoeffizienten.

3. Dielektrische Eigenschaften
Die relative Dielektrizitätskonstante der erfindungsgemäßen Entkopplungsmaterialien ist mit $\varepsilon < 20$ sehr niedrig, sodaß eine sehr gute elektrische Entkopplung zwischen den Schichten elektronischer Bauelemente in Modulen erreicht wird.

Die dielektrischen Verluste liegen ebenfalls niedrig, nämlich bei $tg \, \delta \leq 1 \times 10^{-3}$

**Patentansprüche**

1. Keramischer Schichtverbundkörper (Composite) aus einem elektrokeramisches Material für elektronische Bauelemente und einem elektrisch isolierenden Material für Entkopplungsschichten,
   dadurch gekennzeichnet,
   daß das Material für die Entkopplungsschichten im wesentlichen aus einem einfachen oder substituierten Orthosilikat der Elemente Magnesium, Kalzium, Strontium, Barium und/oder Titan besteht.

2. Keramischer Schichtverbundkörper
   nach Anspruch 1,
   dadurch gekennzeichnet,
   daß das Orthosilikat ein substituiertes Orthosilikat der Zusammensetzung $Ba_{2-x}Sr_xTiSi_2O_8$ mit $0 \leq x \leq 2$, $Ba_{3-x}Ca_xMgSi_2O_8$ mit $0 \leq x \leq 2$ oder $Mg_{2-x}Ca_xSiO_4$ mit $0 \leq x \leq 0.5$ ist.

3. Keramischer Schichtverbundkörper
   nach Anspruch 1 oder 2,
   dadurch gekennzeichnet,
   daß das elektrokeramische Material ein titanhaltiger Perowskit ist.

4. Keramischer Schichtverbundkörper
   nach Anspruch 1 bis 3,
   dadurch gekennzeichnet,
   daß das elektrokeramische Material ein mit Niob, Kobalt und Mangan dotiertes Bariumtitanat ist und das Orthosilikat die Zusammensetzung $Ba_2TiSi_2O_8$, $Ba_{1.6}Sr_{0.2}TiSi_2O_8$, $Sr_2TiSi_2O_8$, $Ba_3MgSi_2O_8$, $Ba_{2.7}Ca_{0.3}MgSi_2O_8$, $BaCa_2MgSi_2O_8$, $Mg_2SiO_4$ oder $Mg_{1.6}Ca_{0.4}SiO_4$ hat.

5. Verfahren zur Herstellung eines keramischen Schichtverbundkörpers
   nach Anspruch 1 bis 4,
   dadurch gekennzeichnet,
   daß der Schichtverbundkörper zunächst als grüner Formkörper gefertigt wird, und anschließend der grüne Formkörper gesintert wird.

6. Modul mit einem keramischen Schichtverbundkörper nach Anspruch 1 bis 4.

7. Modul mit einem keramischen Schichtverbundkörper, gefertigt nach Anspruch 5.

# EP 0 707 952 A1

Europäisches Patentamt

## EUROPÄISCHER RECHERCHENBERICHT

Nummer der Anmeldung

EP 95 20 2661

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int.Cl.6) |
|---|---|---|---|
| X<br>Y | US-A-5 065 275 (T. FUJISAKI ET AL)<br>* das ganze Dokument *<br>--- | 1-3,5-7<br>4 | B32B18/00<br>H05K1/16<br>H01G4/12<br>C04B35/16 |
| Y | WO-A-92 00254 (E.I. DU PONT DE NEMOURS AND COMP)<br>* Ansprüche *<br>--- | 4 | |
| X | PATENT ABSTRACTS OF JAPAN<br>vol. 016 no. 415 (E-1257) ,2.September 1992<br>& JP-A-04 139794 (KYOCERA CORP) 13.Mai 1992,<br>* Zusammenfassung *<br>--- | 1-3,5-7 | |
| X | PATENT ABSTRACTS OF JAPAN<br>vol. 016 no. 582 (E-1300) ,22.Dezember 1992<br>& JP-A-04 233710 (KYOCERA CORP) 21.August 1992,<br>* Zusammenfassung *<br>--- | 1-3 | |
| X | PATENT ABSTRACTS OF JAPAN<br>vol. 017 no. 214 (E-1357) ,27.April 1993<br>& JP-A-04 352381 (KYOCERA CORP) 7.Dezember 1992,<br>* Zusammenfassung *<br>--- | 1-3 | RECHERCHIERTE SACHGEBIETE (Int.Cl.6)<br>B32B<br>H05K<br>H01G<br>C04B |
| X | DATABASE WPI<br>Section Ch, Week 9319<br>Derwent Publications Ltd., London, GB;<br>Class L02, AN 93-155503<br>& JP-A-05 090 070 ( KYOCERA CORP) ,<br>9.April 1993<br>* Zusammenfassung *<br>---<br>-/-- | 1,2 | |

Der vorliegende Recherchenbericht wurde für alle Patentansprüche erstellt

| Recherchenort | Abschlußdatum der Recherche | Prüfer |
|---|---|---|
| BERLIN | 1.Februar 1996 | Kuehne, H-C |

EP 0 707 952 A1

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int.Cl.6) |
|---|---|---|---|
| A | PATENT ABSTRACTS OF JAPAN vol. 015 no. 114 (E-1047) ,19.März 1991 & JP-A-03 004594  (KYOCERA CORP) 10.Januar 1991, * Zusammenfassung * --- | 1-7 | |
| A | PATENT ABSTRACTS OF JAPAN vol. 017 no. 353 (E-1393) ,5.Juli 1993 & JP-A-05 055079  (KYOCERA CORP)  5.März 1993, * Zusammenfassung * --- | 1-7 | |
| A | PATENT ABSTRACTS OF JAPAN vol. 017 no. 591 (C-1125) ,28.Oktober 1993 & JP-A-05 178659  (KYOCERA CORP)  20.Juli 1993, * Zusammenfassung * --- | 1-7 | |
| A | PATENT ABSTRACTS OF JAPAN vol. 016 no. 415 (E-1257) ,2.September 1992 & JP-A-04 139711  (KYOCERA CORP)  13.Mai 1992, * Zusammenfassung * --- | 1-7 | **RECHERCHIERTE SACHGEBIETE (Int.Cl.6)** |
| A | US-A-4 333 842 (Y. ITO ET AL) * das ganze Dokument * ----- | 2,4 | |

Der vorliegende Recherchenbericht wurde für alle Patentansprüche erstellt

| Recherchenort | Abschlußdatum der Recherche | Prüfer |
|---|---|---|
| BERLIN | 1.Februar 1996 | Kuehne, H-C |

KATEGORIE DER GENANNTEN DOKUMENTE

X : von besonderer Bedeutung allein betrachtet
Y : von besonderer Bedeutung in Verbindung mit einer
    anderen Veröffentlichung derselben Kategorie
A : technologischer Hintergrund
O : nichtschriftliche Offenbarung
P : Zwischenliteratur

T : der Erfindung zugrunde liegende Theorien oder Grundsätze
E : älteres Patentdokument, das jedoch erst am oder
    nach dem Anmeldedatum veröffentlicht worden ist
D : in der Anmeldung angeführtes Dokument
L : aus andern Gründen angeführtes Dokument
..................................................................
& : Mitglied der gleichen Patentfamilie, übereinstimmendes
    Dokument

EPO FORM 1503 03.82 (P04C03)